(19) **Europäisches Patentamt**

**European Patent Office**

**Office européen des brevets**

(11) Publication number: **0 023 127**
**B1**

(12) **EUROPEAN PATENT SPECIFICATION**

(45) Date of publication of patent specification: **19.04.89**

(21) Application number: **80302396.9**

(22) Date of filing: **16.07.80**

(51) Int. Cl.⁴: **H 03 K 3/353**

(54) **CMOS Schmitt-trigger circuit.**

(30) Priority: **19.07.79 JP 91969/79**

(43) Date of publication of application:
**28.01.81 Bulletin 81/04**

(45) Publication of the grant of the patent:
**19.04.89 Bulletin 89/16**

(84) Designated Contracting States:
**DE FR GB NL**

(56) References cited:
**US-A-3 882 331**
**US-A-3 984 703**
**US-H- 955 006**

**ELEKTROTECHNIK, vol. 60, no. 3, 10-02-1978; pages 16-18, Würzburg (DE) HADLEY: "CMOS-SCHMITT-TRIGGER", pages 16-18**

(73) Proprietor: **FUJITSU LIMITED**
**1015, Kamikodanaka Nakahara-ku**
**Kawasaki-shi Kanagawa 211 (JP)**

(72) Inventor: **Okamoto, Keizo**
**1616-45 Soubudai-danchi**
**Sagamihara-shi Kanagawa 228 (JP)**
Inventor: **Tomita, Masayoshi**
**103-2-1, Kamikodanaka Nakahara-ku**
**Kawasaki-shi Kanagawa 211 (JP)**
Inventor: **Takagi, Osamu**
**8-11-5-408, Oojima**
**Kohtoh-ku Tokyo 136 (JP)**

(74) Representative: **Rackham, Stephen Neil et al**
**GILL JENNINGS & EVERY 53-64 Chancery Lane**
**London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

# EP 0 023 127 B1

**Description**

This invention relates to a schmitt-trigger circuit constructed by CMOS (Complementary Metal Oxide Semiconductor) inverters connected in cascade.

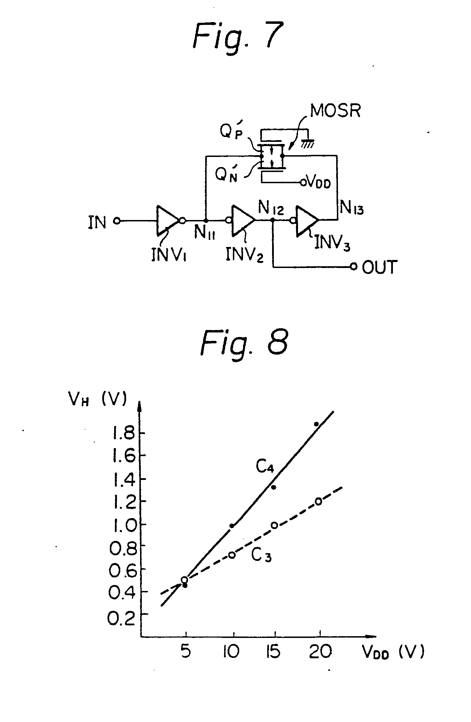

Various logic circuits, such as flip-flops, shift registers, counters, etc., start their operations when the potential voltages of clock signals at their clock input rise or fall. However, if the wave form of a clock signal applied to the clock input of a logic circuit is distorted so that the rising time or falling time of the clock signal is elongated, this often causes an operation error of the logic circuit. In order to avoid the operation error, the clock signal is usually converted so that its wave form has a characteristic of rapid rising time or rapid falling time. Such a characteristic can be obtained by means of a well known schmitt-trigger circuit as a wave-form shaping circuit. It is often required also in a logic circuit that a stable operation be maintained even when the voltage level of the input signal fluctuates within a predetermined margin. The schmitt-trigger circuit is also used for increasing the margin of the input-signal level. The known schmitt-trigger circuit is essentially comprised of two inverters connected in series and a feedback resistor connected to these inverters in parallel. Such a circuit is disclosed in technical literature entitled 'Motorola McMOS'' at p. 216 Figure 8—37. This circuit will be described in detail subsequently with reference to the drawings. The schmitt-trigger circuit is characterised by a parameter called a schmitt width, which is determined by the difference between an upper threshold voltage and a lower threshold voltage, as hereinafter described in detail. It is important that the schmitt width be independent of the input impedance. However, in the known schmitt-trigger circuit, the schmitt width is varied depending on the input impedance.

Therefore, an object of the present invention is to provide a schmitt-trigger circuit whose schmitt width is independent of the impedance of the input signal, and is dependent on the power supply voltage.

According to this invention a CMOS Schmitt-trigger circuit having an input terminal for connection to a signal source, and an output terminal, a first CMOS inverter, a second CMOS inverter connected in cascade to the first CMOS inverter and a feedback resistance connected between the output end of the second CMOS inverter and the input of the first CMOS inverter, is characterized in that the circuit further comprises a third CMOS inverter in cascade with the first and second CMOS inverters and directly connected between the input terminal and the input of the first CMOS inverter, and in that the said feedback resistance comprises a p-channel MOS transistor and an n-channel MOS transistor connected in parallel, the gates of the said MOS transistors being connected to the power supply, and the said feedback resistance being dependent on the voltage of the power supply.

The present invention will be better understood from the following description of embodiments of the invention, with reference to the accompanying drawings, in which like reference characters designate the same or similar parts throughout the figures thereof and wherein:

Figure 1a is a circuit diagram of an inverter as a simple wave-shaping circuit;

Figure 1b is a graph illustrating an input-output characteristic of the circuit of Figure 1a;

Figure 2a is a circuit diagram of a Schmitt-trigger circuit of the prior art;

Figure 2b is an equivalent circuit diagram of the Schmitt-trigger circuit of Figure 2a;

Figure 2c is a graph of an input-output characteristic of the circuit of Figure 2a;

Figure 3 is a circuit diagram of a Schmitt-trigger circuit according to a first step of the present invention;

Figure 4 is a circuit diagram equivalent to the main part of the circuit of Figure 3;

Figure 5 shows experimental and theoretical graphs with respect to the dependency of the Schmitt width on the power supply voltage in the circuit of Figure 3;

Figure 6 is a circuit diagram of a schmitt-trigger circuit according to the present invention;

Figure 7 is an equivalent circuit diagram of the circuit of Figure 6, and;

Figure 8 is experimental and theoretical graphs illustrating the dependency of schmitt width on the power supply voltage in the circuit of Figure 6.

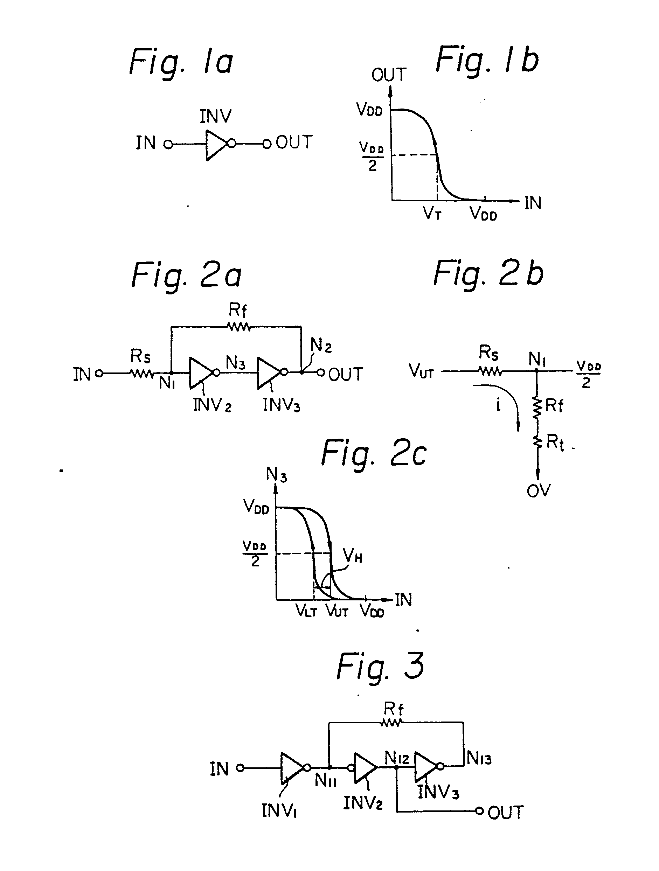

Before describing the preferred embodiments, an inverter and a prior-art schmitt-trigger circuit will first be explained with reference to Figures 1a, 1b, 2a, 2b and 2c.

Figure 1a is a circuit diagram of an inverter INV. As is well known, the voltage level at the input IN is inverted through the inverter at the output OUT. Figure 1b shows an input-output characteristic of this inverter INV. As shown in Figure 1b, the output voltage level is high or low depending on the low or high level of the input voltage respectively. When the inverter INV is constructed by a CMOS, the CMOS is often designed to have a threshold voltage $V_T$ of $V_{DD}/2$ for turning on or off, where $V_{DD}$ represents the power supply voltage applied across the CMOS. The threshold voltage of $V_{DD}/2$ is preferable for the purpose of increasing the margin of the input voltage. In the following description, it is assumed that the threshold voltage of a CMOS inverter is $V_{DD}/2$. As will be seen in Figure 1b, a single inverter has no hysteresis curve with respect to the input and output voltages. Therefore, the output voltage is turned from a high level to a low level or vice versa when the input voltage reaches the threshold voltage $V_T$ during the rising or falling of the input voltage respectively.

A schmitt-trigger circuit in the prior art is illustrated in Figure 2a, in which the schmitt-trigger circuit is comprised of two CMOS inverters $INV_2$ and $INV_3$ connected in series, and a feedback resistance Rf connected in parallel to the two CMOS inverters $INV_2$ and $INV_3$. There is an input resistance Rs between the

connecting point $N_1$ and the input terminal IN of the schmitt-trigger circuit, where the connecting point $N_1$ connects the input resistance Rs and the input end of the inverter $INV_2$. The input resistance Rs includes the impedance of a signal source (not shown) connected to the input terminal IN. Since the inverters $INV_2$ and $INV_3$ are connected in series, the voltage phase at the connecting point $N_1$ of the inverter $INV_2$ is equal to that at a connecting point $N_2$ between the output end of the inverter $INV_3$ and the output terminal OUT. When the voltages at the connecting points $N_1$ and $N_2$ are both zero volts, the voltage at the connecting point $N_3$ between the inverters $INV_2$ and $INV_3$ is equal to the power supply voltage $V_{DD}$. On the contrary, when the voltages at the connecting points $N_1$ and $N_2$ are both $V_{DD}$, the voltage at the connecting point $N_3$ is equal to zero volts.

Figure 2b is an equivalent circuit diagram of the schmitt-trigger circuit of Figure 2a. Since the input resistance of the inverter $INV_2$ or $INV_3$ can be recognized as infinite, and since the output resistance of the inverter $INV_3$ is equal to the resistance Rt equivalent to the resistance of the p-channel or n-channel FET in the output side of the CMOS inverter $INV_3$, the equivalent circuit is comprised of the input resistance Rs, the feedback resistance $R_f$ and the equivalent resistance $R_t$ connected in series.

In operation, when the input voltage reaches a value $V_{UT}$ during the increasing of the input voltage from zero volts to $V_{DD}$, the voltage at the connecting point $N_1$ of the inverter $INV_2$ reaches $V_{DD}/2$, so that the voltage level at the output of the inverter $INV_2$ is turned from $V_{DD}$ to zero volts, and then, the voltage level at the output of the inverter $INV_3$ is turned from zero volts to $V_{DD}$. In Figure 2c, the change of the voltage at the connecting point $N_3$ is illustrated with respect to the input voltage. The voltage $V_{UT}$ is referred to as an upper threshold voltage. If it is assumed that the current flowing through the input resistor $R_s$ is i, the following equation is obtained.

$$V_{UT} - \frac{V_{DD}}{2} = i \cdot R_s \qquad (1)$$

The equivalent resistance $R_t$ can be neglected because the feedback resistance $R_f$ is much greater than the equivalent resistance $R_t$. Therefore, the following equation is also obtained.

$$\frac{V_{DD}}{2} = i \cdot R_f \qquad (2)$$

From the above two equations, the upper threshold voltage $V_{UT}$ can be expressed as:

$$V_{UT} = \frac{V_{DD}}{2} \cdot \frac{R_f + R_s}{R_f} \qquad (3)$$

On the contrary, when the input voltage reaches a value $V_{LT}$ during the decreasing of the input voltage from $V_{DD}$ to zero volts, the voltage at the input end $N_1$ of the inverter $INV_2$ reaches $V_{DD}/2$, so that the voltage level at the output of the inverter $INV_2$ is turned from zero volts to $V_{DD}$, and then, the voltage level at the output of the inverter $INV_3$ is turned from $V_{DD}$ to zero volts. The voltage $V_{LT}$ is referred to as a lower threshold voltage. In this case, since the output voltage is higher than the input voltage, current i flows from the output terminal OUT to the input terminal IN. Therefore, the following equation is obtained.

$$\frac{V_{DD}}{2} - V_{LT} = i \cdot R_s \qquad (4)$$

From the equations (2) and (4), the lower threshold voltage can be expressed as:

$$V_{LT} = \frac{V_{DD}}{2} \cdot \frac{R_f - R_s}{R_f} \qquad (5)$$

Consequently, the upper threshold voltage $V_{UT}$ differs from the lower threshold voltage $V_{LT}$. Therefore, the CMOS inverter in the schmitt-trigger circuit of Figure 2a has a hysteresis curve with respect to the input and output voltages of the inverter. Figure 2c illustrates a hysteresis curve of the inverter $INV_2$. In Figure 2c, the difference between the upper threshold voltage and the lower threshold voltage is referred to as a schmitt width $V_H$. From the above equations (3) and (4), the schmitt width $V_H$ can be expressed as:

$$V_H = V_{UT} - V_{LT} = \frac{R_s}{R_f} \times V_{DD} \qquad (6)$$

3

As will be understood from the equation (6), according to the prior-art schmitt-trigger circuit, the schmitt width $V_H$ depends on the input resistance $R_s$. As previously mentioned, the input resistance $R_s$ includes the impedance of the input-signal source. Therefore, there is a disadvantage in the prior-art schmitt-trigger circuit that the schmitt width $V_H$ varies depending on the variation of the impedance of the input-signal source. According to a first step leading towards the invention, the schmitt width is independent of the power supply voltage. According to the invention the schmitt width is dependent on the power supply voltage.

Figure 3 is a circuit diagram of a schmitt-trigger circuit leading towards the present invention, in which, the schmitt-trigger circuit is comprised of three CMOS inverters $INV_1$ through $INV_3$ connected in cascade, and a feedback resistance Rf connected between a connecting point $N_{13}$ connected to the output end of the inverter $INV_3$ and the connecting point $N_{11}$ between the inverters $INV_1$ and $INV_2$. The input terminal IN is connected to the inverter $INV_1$, and the output terminal OUT is connected to the connecting point $N_{12}$ between the inverters $INV_2$ and $INV_3$. By this construction, the phase of the output voltage at the output terminal OUT is the same as that of the input voltage at the input terminal IN.

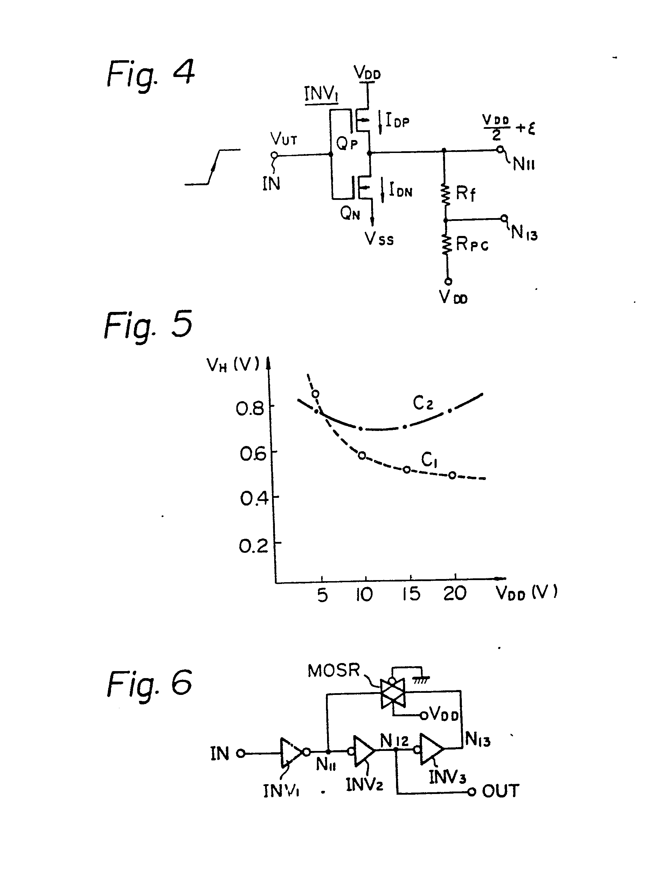

Figure 4 is an equivalent circuit diagram of the schmitt-trigger circuit of Figure 3. In Figure 4, the inverter $INV_1$ is comprised of a p-channel MOS transistor $Q_P$ and the n-channel MOS transistor $Q_N$. The gates of both MOS transistors are connected together to the input terminal IN. The source of the MOS transistor $Q_P$ and the drain of the MOS transistor $Q_N$ are connected together to the connecting point $N_{11}$. The inverters $INV_2$ and $INV_3$ both have the same constructions as the inverter $INV_1$. However, in order to avoid complexity, the circuit stage followed by the inverter $INV_1$ can be expressed by the feedback resistance Rf and a resistance Rpc connected in series, where the resistance Rpc represents the resistance of the p-channel MOS transistor in the inverter $INV_3$ when the p-channel MOS transistor is in an on state.

The operation of the circuit of Figure 3 will now be described in detail. When the input voltage at the input terminal IN is zero volts, the voltage at the connecting point $N_{11}$ of the inverter $INV_1$ is equal to the power supply voltage $V_{DD}$, the voltage at the connecting point $N_{12}$ of the inverter $INV_2$ is equal to the ground voltage $V_{SS}$ which is equal to zero volts, and the voltage at the connecting point $N_{13}$ of the inverter $INV_3$ is equal to $V_{DD}$. In this condition, when the input voltage at the input terminal IN is increased from zero volts to $V_{DD}$, the voltage at the point $N_{11}$ will then be decreased from $V_{DD}$ toward zero volts.

The voltage at the point $N_{11}$ is determined not only by the output voltage of the inverter $INV_1$, but also, by the feedback current flowing through the resistance $R_{pc}$ and the feedback resistance Rf from the point $N_{13}$ to the point $N_{11}$. The effect of the feedback current on the voltage at the point $N_{11}$ is expressed in Figure 4 by the notation "$\varepsilon$". Thus, the voltage at the point $N_{11}$ shortly before turning the state of the inverter $INV_2$ is expressed as:

$$\frac{V_{DD}}{2}+\varepsilon$$

as shown in Figure 4. When the input voltage at the input terminal IN is close to the upper threshold voltage $V_{UT}$ during the increasing of the input voltage from zero volts to $V_{DD}$, the P-channel transistor $Q_p$ and the n-channel transistor $Q_N$ in the inverter $INV_1$ are both in a state of saturation. The condition of the p-channel transistor and the n-channel transistor being in the state of saturation is:

$$(\frac{V_{DD}}{2}+\varepsilon)- \mid V_{TP} \mid \leq V_{UT}<(\frac{V_{DD}}{2}+\varepsilon)+V_{TN} \tag{7}$$

where $V_{TP}$ and $V_{TN}$ represent the threshold voltages of the p-channel transistor $Q_p$ and the n-channel transistor $Q_N$, respectively. The drain currents $I_{DN}$ and $I_{DP}$ of the p-channel transistor $Q_p$ and the n-channel transistor $Q_N$, respectively, in their saturated states can be expressed as:

$$I_{DN}=\frac{\beta_N}{2}(V_{UT}-V_{TN})^2 \tag{8}$$

$$I_{DP}=\frac{\beta_P}{2}(V_{UT}-V_{DD}-V_{TP})^2 \tag{9}$$

where $\beta_N$ and $\beta_p$ represent the $\beta$ factors of the n-channel transistor $Q_N$ and the p-channel transistor $Q_p$, respectively. Also, according to Kirchhoff's law, the relation between the drain currents $I_{DP}$ and $I_{DN}$ can be expressed as:

$$I_{DP}=I_{DN}- \frac{V_{DD}}{2(R_f+R_{PC})} \tag{10}$$

4

where $\varepsilon$ is neglected because $V_{DD}$ is much greater than $\varepsilon$. For the purpose of simplification, let it be assumed that:

$$\beta_N = \beta_P, \text{ and}$$

$$V_{TN} = -V_{TP}$$

Using the above relations as well as the relations (8) and (9), the relation (10) can be expressed as:

$$\frac{\beta_N}{2}(V_{UT} - V_{TN})^2 = \frac{\beta_N}{2}(V_{UT} - V_{DD} + V_{TN})^2 + \frac{V_{DD}}{2(R_f + R_{pc})}$$

Therefore, the upper threshold voltage $V_{UT}$ can be expressed as:

$$V_{UT} = \frac{V_{DD}}{2\beta_N(V_{DD} - 2V_{TN})} \times \frac{1}{R_f + R_{pc}} + \frac{1}{2}V_{DD} \qquad (11)$$

Also, the difference between the upper threshold voltage $V_{UT}$ and the threshold voltage of an inverter can be expressed as:

$$\Delta V_{UT} = V_{UT} - \frac{1}{2}V_{DD} = \frac{1}{2\beta_N}\left(1 + \frac{2V_{TN}}{V_{DD} - 2V_{TN}}\right)\frac{1}{R_f + R_{pc}} \qquad (12)$$

The lower threshold voltage $V_{LT}$ can also be obtained in a similar manner to that in which the upper threshold voltage has been obtained. The lower threshold voltage $V_{LT}$ can be expressed as:

$$V_{LT} = \frac{V_{DD}}{2\beta_N(V_{DD} - 2V_{TN})} \times \frac{1}{R_f + R_{NC}} + \frac{1}{2}V_{DD} \qquad (13)$$

The difference between the voltage $V_{LT}$ and the threshold voltage of an inverter is:

$$\Delta V_{LT} = \frac{1}{2}V_{DD} - V_{LT} = -\frac{1}{2\beta_N}\left(1 + \frac{2V_{TN}}{V_{DD} - 2V_{TN}}\right)\frac{1}{R_f + R_{NC}} \qquad (14)$$

where $R_{NC}$ represents the resistance of the n-channel transistor (not shown) in the inverter INV$_3$, when the n-channel transistor is in a on state.

Let it be assumed that the resistance $R_{PC}$ is equal to the resistance $R_{NC}$. Then, the schmitt width $V_H$ of the schmitt-trigger circuit of Figure 3 is:

$$V_H = \Delta V_{UT} - \Delta V_{LT} = \frac{1}{\beta_N}\left(1 + \frac{2V_{TN}}{V_{DD} - 2V_{TN}}\right)\frac{1}{R_f + R_{NC}} \qquad (15)$$

In the equation (15), $\beta_N$ is independent of the power supply voltage $V_{DD}$ and the term

$$\left(1 + \frac{2V_{TN}}{V_{DD} + 2V_{TN}}\right)$$

is not largely dependent on $V_{DD}$ if $V_{DD}$ is much higher than $V_{TN}$. Also, since the feedback resistance $R_f$ is generally much larger than the resistance $R_{NC}$, the term

$$\frac{1}{R_f + R_{NC}}$$

is nearly equal to

$$\frac{1}{R_f}$$

and thus has almost no dependence on $V_{DD}$. Consequently, the schmitt width $V_H$ according to this embodiment has an almost constant value regardless of the value of the power supply voltage $V_{DD}$. In addition, since there is no input resistance Rs in the equation (15), the schmitt width $V_H$ is independent of the impedance of the input-signal source. That is, since the input impedance of the CMOS inverter $INV_1$ can be deemed infinite, $V_H$ is independent of the impedance of the input-signal source which may be connected to the input terminal IN.

Figure 5 is composed of two graphs, one being experimental and another being theoretical, with respect to the dependency of the schmitt width on the power supply voltage in the circuit of Figure 3. In Figure 5, the dotted curve $C_1$ is the theoretical graph and the solid curve $C_2$ is the experimental graph. In both cases, these curves are obtained under the conditions: $\beta_N$=65 µv/V, $V_{TN}$=1.25 V, $R_f$=23 kΩ, and

$$R_{NC}(V_{DD}=5V)=2k\Omega.$$

As can be seen from the experimental curve $C_2$, the schmitt width $V_H$ varies only within 0.1 volt when the power supply voltage $V_{DD}$ varies from 5V to 20V. Although the relations between $\beta_N$ and $\beta_p$, $V_{TN}$ and $V_{TP}$, and $R_{PC}$ and $R_{NC}$ are assumed as $\beta_N=\beta_p$, $V_{TN}=-V_{TP}$ and $R_{PC}=R_{NC}$, respectively, in this embodiment, these relations are not restricted to those assumed, but may be changed depending on the applied field of the schmitt-trigger circuit.

It is required that the dependency of the schmitt width $V_H$ on the power supply voltage $V_{DD}$ varies depending on the variation of the power supply voltage $V_{DD}$, for the purpose of, for example, reducing the influence from the power supply noise. Figure 6 illustrates a schmitt-trigger circuit according to the present invention, in which the schmitt width $V_H$ depends on the power supply voltage $V_{DD}$, as will be apparent from the following description. The difference between the circuits of Figure 3 and Figure 6 is that, in place of the feedback resistance Rf in Figure 3, a resistor element MOSR comprised of two MOS transistors is used in Figure 6. Figure 7 is an equivalent circuit diagram of Figure 6. As illustrated in Figure 7, the resistor element MOSR is comprised of a p-channel MOS transistor $Q'_p$ and an n-channel MOS transistor $Q'_N$ connected in parallel. The sources of the transistors $Q'_p$ and $Q'_N$ are commonly connected to the connecting point $N_{11}$. The drains of the transistors $Q'_p$ and $Q'_N$ are commonly connected to the output end $N_{13}$ of the inverter $INV_3$. The gate of the transistor $Q'_p$ is grounded. The ground voltage may be negative because the ground voltage is determined by a lower voltage terminal of the power supply. The gate of the transistor $Q'_N$ is connected to the power supply voltage $V_{DD}$. By this construction, when the power supply voltage $V_{DD}$ varies, the resistance through the MOSR, which corresponds to the feedback resistance $R_f$ in Figure 3, will accordingly be varied. Therefore, the resistance of the MOSR is a function of the power supply voltage $V_{DD}$. When the voltage $V_{DD}$ increases or decreases, the resistance of the MOSR will decrease or increase respectively. If the resistance of the MOSR is indicated also by the notation $R_f$, the above described equations (7) through (14) are also satisfied in the circuit of Figure 6. Let it be assumed that the resistance $R'_p$ of the p-channel transistor $Q'_p$ in its on state is equal to the resistance $R'_N$ of the n-channel transistor $Q'_N$ in its on state. Also, in the CMOS inverter $INV_3$, the resistance $R_{pc}$ of the p-channel transistor is assumed to be equal to the resistance $R_{NC}$ of the n-channel transistor. Then, the following equation (16) similar to the equation (15) is satisfied in this embodiment.

$$V_H=\Delta V_{UT}-\Delta V_{LT}=\frac{1}{\beta_N}\left(1+\frac{2V_{TN}}{V_{DD}-2V_{TN}}\right)\cdot\frac{1}{R_f+R_{NC}}$$

Referring to the equation (16), the factor $\beta_N$ does not also depend on the power supply voltage $V_{DD}$. Also, the term

$$\left(1+\frac{2V_{TN}}{V_{DD}-2V_{TN}}\right)$$

is not largely dependent on $V_{DD}$, as in the case of the equation (15). However, the term $(R_f+R_{NC})$ in the equation (16) depends largely on the power supply voltage $V_{DD}$, because the resistance Rf and $R_{NC}$ are both resistances of MOS transistors in their on states. Therefore, the term $(R_f+R_{NC})$ is inversely proportional to the power supply voltage $V_{DD}$. Consequently, in the schmitt-trigger circuit of Figure 6, the schmitt width $V_H$ is not dependent on the impedance of the input signal source but varies in proportion to the power supply voltage $V_{DD}$.

Figure 8 is composed of two graphs, one being experimental and another being theoretical, with respect to the dependency of the schmitt width on the power supply voltage in the circuit of Figure 6. In Figure 8, the dotted curve $C_3$ is the theoretical graph and the solid curve $C_4$ is the experimental graph. In both cases these curves are obtained under the conditions: $V_{TN}$=1.25 V, $\beta_N$=65 µv/V, $R_{NC}(V_{DD}=5$ V)=2 kΩ, and Rf($V_{DD}=5$ V)=40 kΩ. As can be seen from Figure 8, the schmitt width $V_H$ increases proportionally along with the increase of the power supply voltage $V_{DD}$. It is useful for a CMOS, which is to be used in a wide range of power supply voltage, that the schmitt width $V_H$ increases proportionally to the increase in the

power supply voltage $V_{DD}$. For example, when a high power supply voltage $V_{DD}$ is applied to a logic circuit connected to the schmitt-trigger circuit, the time required for the rising or falling of the potential voltage of the clock signal is elongated, so that the possibility of an error operation in the logic circuit is increased. In order to avoid the error operation, a wide schmitt width is required. Therefore, the schmitt-trigger circuit of Figure 6 is suitable for this case. In addition, in order to increase the margin of the input noise in the logic circuit, a high power-supply voltage is applied to the logic circuit. In this case, the schmitt-trigger circuit of Figure 6, which has a wide schmitt width when the power supply voltage $V_{DD}$ is high, is suitable.

From the foregoing description, it will be understood that the schmitt-trigger circuit according to the present invention has a schmitt-width independent from the impedance of the input signal source. Therefore, the schmitt-trigger circuit is suitable for a wave-form shaping circuit for driving logic circuits such as flip-flops, counters, etc.

It should be noted that the feedback resistance $R_f$ can be integrated within a CMOS IC because the resistance $R_f$ is formed by MOS transistors.

## Claims

1. A CMOS Schmitt-trigger circuit having an input terminal (IN, Figure 3) for connection to a signal source, and an output terminal (OUT), a first CMOS inverter (INV$_2$), a second CMOS inverter (INV$_3$) connected in cascade to the first CMOS inverter and a feedback resistance (MOSR) connected between the output end (N$_{13}$) of the second CMOS inverter (INV$_3$) and the input (N$_{11}$) of the first CMOS inverter, characterized in that the circuit further comprises a third CMOS inverter (INV$_1$) in cascade with the first and second CMOS inverters and directly connected between the input terminal (IN) and the input (N$_{11}$) of the first CMOS inverter (INV$_2$), and in that the said feedback resistance (MOSR, Figure 6) comprises a p-channel MOS transistor (Q$'_p$, Figure 7) and an n-channel MOS transistor (Q$'_n$) connected in parallel, the gates of the said MOS transistors being connected to the power supply, and the said feedback resistance being dependent on the voltage of the power supply.

2. A CMOS Schmitt-trigger circuit according to claim 1, in which the output terminal (OUT) is connected to the output (N$_{12}$) of the first CMOS inverter.

3. An integrated circuit including a CMOS Schmitt-trigger circuit according to any preceding claim, wherein the feedback resistance is integrated into the same semiconductor substrate as the transistors of the CMOS inverters.

## Patentansprüche

1. CMOS-Schmitt-Triggerschaltung mit einem Eingangsanschluß (IN, Fig. 3) zum Verbinden einer Signalquelle, und einem Ausgangsanschluß (OUT), einem ersten CMOS-Inverter (INV$_2$) und einem zweiten CMOS-Inverter (INV$_3$), der in Kaskade mit dem ersten CMOS-Inverter verbunden ist, und einem Rückkopplungswiderstand (MOSR), der zwischen dem Ausgangsende (N$_{13}$) des zweiten CMOS-Inverters (INV$_3$) und dem Eingang (N$_{11}$) des ersten CMOS-Inverters verbunden ist, dadurch gekennzeichnet, daß die genannte Schaltung ferner einen dritten CMOS-Inverter (INV$_1$) umfaßt, der in Kaskade mit den ersten und zweiten CMOS-Invertern und direkt zwischen dem Eingangsanschluß (IN) und dem Eingang (N$_{11}$) des ersten CMOS-Inverters (INV$_2$) verbunden ist, und daß der genannte Rückkopplungswiderstand (MOSR, Fig. 6) einen p-Kanal-MOS-Transistor (Q$'_p$, Fig. 7) und einen n-Kanal-MOS-Transistor (Q$'_n$) umfaßt, die parallel angeschlossen sind, wobei die Gates der genannten MOS-Transistoren mit der Energieversorgung verbunden sind, und der genannte Rückkopplungswiderstand von der Spannung der Energieversorgung abhängt.

2. CMOS-Schmitt-Triggerschaltung nach Anspruch 1, bei der der Ausgangsanschluß (OUT) mit dem Ausgang (N$_{12}$) des ersten CMOS-Inverters verbunden ist.

3. Integrierte Schaltung mit einer CMOS-Schmitt-Triggerschaltung nach einem der vorhergehenden Ansprüche, bei der der Rückkopplungswiderstand in dasselbe Halbleitersubstrat wie die Transistoren der CMOS-Inverter integriert ist.

## Revendications

1. Circuit basculeur de Schmitt CMOS avec une borne d'entrée (IN, figure 3) destinée à être connectée à une source de signaux et une borne de sortie (OUT), un premier inverseur CMOS (INV$_2$), un second inverseur CMOS (INV$_3$) connecté en cascade avec le premier inverseur CMOS et une résistance de réaction (MOSR) connectée entre l'extrémité de sortie (N$_{13}$) du second inverseur CMOS (INV$_3$) et l'entrée (N$_{11}$) du premier inverseur CMOS, caractérisé en ce que le circuit comporte en outre un troisième inverseur CMOS (INV$_1$) en cascade avec le premier et le second inverseurs CMOS et connecté directement entre la borne d'entrée (IN) et l'entrée (N$_{11}$) du premier inverseur CMOS (INV$_2$), et en ce que ladite résistance de réaction (MOSR, figure 6) comporte un transistor MOS à canal P (Q$'_p$, figure 7) et un transistor MOS à canal N (Q$'_N$) connectés en parallèle, les grilles desdits transistors MOS étant connectées à la source d'alimentation et ladite résistance de réaction dépendant de la tension de la source d'alimentation.

2. Circuit basculeur de Schmitt CMOS selon la revendication 1, dans lequel la borne de sortie (OUT) est connectée à la sortie ($N_{12}$) du premier inverseur CMOS.

3. Circuit intégré comprenant un circuit basculeur de Schmitt CMOS selon l'une quelconque des revendications précédentes, dans lequel la résistance de réaction est intégrée dans le même substrat semi-conducteur que les transistors des inverseurs CMOS.

*Fig. 1a*

INV

IN o———|>o——o OUT

*Fig. 1b*

OUT

V_DD

$\frac{V_{DD}}{2}$

V_T    V_DD    IN

*Fig. 2a*

Rf

Rs        N_3        N_2

IN o——/\/\——|>o———|>o——o OUT
         N_1
        INV_2    INV_3

*Fig. 2b*

Rs        N_1        $\frac{V_{DD}}{2}$

V_UT o——/\/\——•——
              
         i      Rf

                Rt

                OV

*Fig. 2c*

N_3

V_DD

$\frac{V_{DD}}{2}$         V_H

V_LT  V_UT  V_DD    IN

*Fig. 3*

Rf

IN o——|>o———|>o——|>o——
       INV_1  N_11  INV_2  N_12  INV_3  N_13
                                    o OUT

1

*Fig. 4*

*Fig. 5*

*Fig. 6*

# Fig. 7

# Fig. 8